# EUROPEAN PATENT APPLICATION

(11) **EP 4 679 993 A1**
(43) Date of publication of application: **14.01.2026**
(21) Application number: 25188118.1
(22) Date of filing: 08.07.2025
(51) Int. Cl.: H10K 59/80

(54) **DISPLAY APPARATUS, METHOD OF MANUFACTURING THE SAME, AND ELECTRONIC APPARATUS INCLUDING DISPLAY APPARATUS**

(30) Priority: 11.07.2024 KR 20240091820
(71) Applicant: Samsung Display Co., Ltd., Yongin-si, Gyeonggi-do 17113 (KR)
(72) Inventor: SUNG, Wooyong, 17113 Yongin-si (KR); SONG, Seungyong, 17113 Yongin-si (KR)
(74) Representative: Marks & Clerk LLP

(57) **Abstract**

A display apparatus includes a light-emitting element disposed on a substrate. An inorganic layer is disposed on the light-emitting element. An anti-reflection layer disposed on the inorganic layer. A compressive stress of at least a portion of the inorganic layer is about 200 MPa or greater.

## Description

### TECHNICAL FIELD

One or more embodiments relate to a display apparatus, a method of manufacturing the display apparatus, and an electronic apparatus including the display apparatus.

### DISCUSSION OF THE RELATED ART

Recently, electronic apparatuses have become widely used in both mobile and stationary form factors. Many of these devices incorporate display components that present visual information, such as images and video, to support their function.

Among such display apparatuses, organic light-emitting diode (OLED) display apparatuses have gained attention as next-generation solutions, offering advantages such as wide viewing angles, high contrast, and fast response times.

Typically, an organic light-emitting display consists of a thin-film transistor and an organic light-emitting diode (OLED) formed on a substrate. The OLEDs emit light independently, making them well suited for use in products of varying sizes, from small devices like mobile phones to larger products, such as a televisions.

### SUMMARY

A display apparatus includes a light-emitting element disposed on a substrate, an inorganic layer disposed on the light-emitting element, and an anti-reflection layer disposed on the inorganic layer. At least a portion of the inorganic layer has a compressive stress.

The compressive stress of the at least a portion of the inorganic layer may be 200 MPa or greater.

The inorganic layer may include silicon nitride.

The anti-reflection layer may include a polarizing film.

The anti-reflection layer may be in direct contact with the inorganic layer.

The inorganic layer may include a first layer, and a second layer disposed on the first layer. The second layer may be an upper surface of the inorganic layer. A compressive stress of the second layer may be different from a compressive stress of the first layer.

The compressive stress of the second layer may be greater than the compressive stress of the first layer.

The compressive stress of the second layer may be about 200 MPa or greater.

A density of the second layer may be greater than a density of the first layer.

The density of the second layer may be about 2.0 g/cm³ or greater.

A thickness of the second layer may be within a range of about 10% to about 15% of a total thickness of the inorganic layer.

A compressive stress of the entire inorganic layer may be about 200 MPa or greater.

A density of the entire inorganic layer may be 2.0 g/cm³ or greater.

The display apparatus may further include an encapsulation layer covering the light-emitting element. The encapsulation layer may include a first inorganic encapsulation layer, a second inorganic encapsulation layer disposed on the first inorganic encapsulation layer, and an organic encapsulation layer disposed between the first inorganic encapsulation layer and the second inorganic encapsulation layer.

The inorganic layer may include (e.g. is) the second inorganic encapsulation layer.

The display apparatus may further include a touch sensor layer disposed on the encapsulation layer. The touch sensor layer may include a first insulating layer, a first conductive layer disposed on the first insulating layer, a second insulating layer disposed on the first conductive layer, a second conductive layer disposed on the second insulating layer, and a third insulating layer disposed on the second conductive layer. The inorganic layer may include (e.g. is) the third insulating layer.

A method of manufacturing a display apparatus includes forming a light-emitting element on a substrate. An inorganic layer including silicon nitride is formed on the light-emitting element. An anti-reflection layer is formed on the inorganic layer. At least a portion of the inorganic layer is formed with a compressive stress.

The compressive stress of the at least a portion of the inorganic layer is about 200 MPa or greater.

The forming of the inorganic layer may be performed at a temperature of about 100 °C or lower.

The forming of the inorganic layer may include forming a first layer, and forming a second layer on the first layer. A compressive stress of the second layer may be about 200 MPa or greater.

In the forming of the inorganic layer, an amount of ammonia (NH₃) injected in the forming of the second layer may be less than an amount of ammonia (NH₃) injected in the forming of the first layer.

In the forming of the inorganic layer, an amount of hydrogen (H₂) injected in the forming of the second layer may be greater than an amount of hydrogen (H₂) injected in the forming of the first layer.

An electronic apparatus includes a display apparatus. The display apparatus includes a light-emitting element disposed on a substrate, an inorganic layer disposed on the light-emitting element, and an anti-reflection layer disposed on the inorganic layer. At least a portion of the inorganic layer has a compressive stress.

The compressive stress of the at least a portion of the inorganic layer is about 200 MPa or greater.

The display apparatus may further include a display module, a processor, a power module, and a memory. The display apparatus may include one of the display module, the processor, the power module, and the memory.

The inorganic layer may include silicon nitride.

The anti-reflection layer may include a polarizing film, and the anti-reflection layer may be in direct contact with the inorganic layer.

The inorganic layer may include a first layer, and a second layer disposed on the first layer. The second layer may be an upper surface of the inorganic layer. A compressive stress of the second layer may be greater than a compressive stress of the first layer.

The compressive stress of the second layer may be about 200 MPa or greater.

A thickness of the second layer may be within a range of about 10% to about 15% of a total thickness of the inorganic layer.

A compressive stress of the entire inorganic layer may be about 200 MPa or greater.

The display apparatus may further include an encapsulation layer covering the light-emitting element. The encapsulation layer may include a first inorganic encapsulation layer, a second inorganic encapsulation layer disposed on the first inorganic encapsulation layer, and an organic encapsulation layer disposed between the first inorganic encapsulation layer and the second inorganic encapsulation layer.

The inorganic layer may include the second inorganic encapsulation layer.

The display apparatus may further include a touch sensor layer disposed on the encapsulation layer. The touch sensor layer may include a first insulating layer, a first conductive layer disposed on the first insulating layer, a second insulating layer disposed on the first conductive layer, a second conductive layer disposed on the second insulating layer, and a third insulating layer disposed on the second conductive layer. The inorganic layer may include the third insulating layer.

At least some of the above and other features of the invention are set out in the claims.

### BRIEF DESCRIPTION OF THE DRAWINGS

The above and other aspects and features of certain embodiments of the disclosure will be more apparent from the following description taken in conjunction with the accompanying drawings, in which:
FIG. 1 is a plan view schematically illustrating an electronic apparatus according to an embodiment;
FIG. 2 is a cross-sectional view schematically illustrating an electronic apparatus, taken along line A-A' of FIG. 1, according to an embodiment;
FIGS. 3A and 3B are equivalent circuit diagrams schematically illustrating a light-emitting element of a display apparatus and a sub-pixel circuit electrically connected to the light-emitting element, according to an embodiment;
FIG. 4A is a cross-sectional view schematically illustrating a portion of a display area of a display apparatus, according to an embodiment;
FIG. 4B is a cross-sectional view schematically illustrating a portion of a display area of a display apparatus, according to an embodiment;
FIG. 5 is a cross-sectional view schematically illustrating a portion of a display apparatus, according to an embodiment;
FIG. 6 is a cross-sectional view schematically illustrating a portion of a display apparatus, according to an embodiment;
FIG. 7 is a cross-sectional view schematically illustrating a portion of a display apparatus, according to an embodiment;
FIG. 8 is a flowchart schematically illustrating a method of manufacturing a display apparatus, according to an embodiment;
FIG. 9 is a block diagram illustrating an electronic apparatus according to an embodiment; and
FIG. 10 depicts schematic diagrams of electronic apparatuses according to various embodiments.

### DETAILED DESCRIPTION

As the disclosure allows for various changes and numerous embodiments, certain embodiments will be illustrated in the drawings and described in the detailed description. Effects and features of the disclosure, and methods for achieving them will be clarified with reference to embodiments described below in detail with reference to the drawings. However, the disclosure is not necessarily limited to the following embodiments and may be embodied in various forms.

Hereinafter, embodiments will be described in detail with reference to the accompanying drawings, wherein to the extent that an element is not described in detail with respect to certain figures, it may be understood that the element is at least similar to a corresponding element that has been described elsewhere within the present disclosure.

Although the terms "first," "second," etc. may be used to describe various elements, these elements should not necessarily be limited by these terms. These terms are used to distinguish one element from another.

As used herein, the singular forms "a," "an," and "the" are intended to include the plural forms as well, unless the context clearly indicates otherwise.

It will be further understood that the term "comprises" or "comprising" used herein specifies the presence of stated features or components, but do not preclude the presence or addition of one or more other features or components.

It will be further understood that, when a layer, region, or component is referred to as being "on" another layer, region, or component, it may be directly on the other layer, region, or component, or may be indirectly on the other layer, region, or component with intervening layers, regions, or components therebetween.

While each drawing may represent one or more particular embodiments of the present disclosure, drawn to scale, such that the relative lengths, thicknesses, and angles can be inferred therefrom, it is to be understood that the present invention is not necessarily limited to the relative lengths, thicknesses, and angles shown. Changes to these values may be made within the scope of the present disclosure, for example, to allow for manufacturing limitations and the like.

When a certain embodiment may be implemented differently, a specific process order may be different from the described order. For example, two consecutively described processes may be performed substantially at the same time or may be performed in an order opposite to the described order.

In the present specification, the expression "A and/or B" indicate only A, only B, or both A and B. Also, the expression "at least one of A or B" indicate only A, only B, or both A and B.

It will be understood that when a layer, a region, or a component is referred to as being "connected" to another layer, region, or component, it may be "directly connected" to the other layer, region, or component and/or may be "indirectly connected" to the other layer, region, or component with other layers, regions, or components disposed therebetween. For example, when a layer, a region, or a component is referred to as being "electrically connected," it may be directly electrically connected, and/or may be indirectly electrically connected with intervening layers, regions, or components therebetween.

An x-axis, a y-axis and a z-axis are not necessarily limited to three axes of a rectangular Cartesian coordinate system, and may be interpreted in a broader sense. For example, the x-axis, the y-axis, and the z-axis may be perpendicular to one another, or may represent different directions that are not perpendicular to one another.

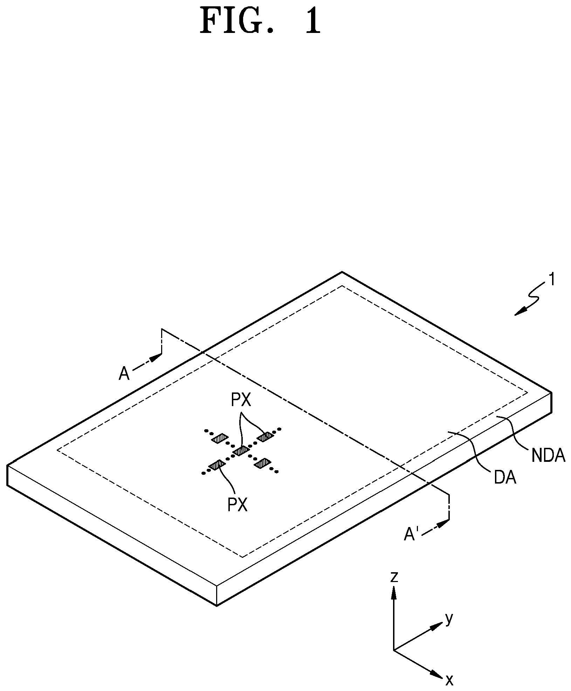

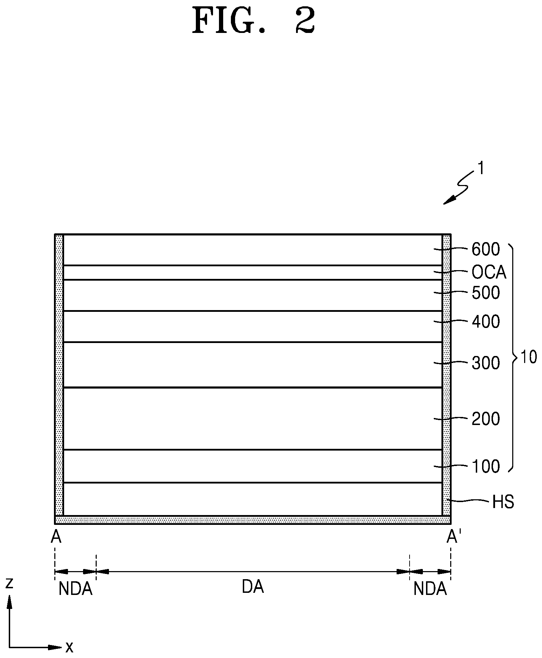

FIG. 1 is a plan view schematically illustrating an electronic apparatus according to an embodiment. In addition, FIG. 2 is a cross-sectional view schematically illustrating the electronic apparatus, taken along line A-A' of FIG. 1, according to an embodiment.

Referring to FIGS. 1 and 2, an electronic apparatus 1 is configured to display a video or a still image, and may be used as a display screen of not only a portable electronic apparatus, such as a mobile phone, a smartphone, a tablet computer, a mobile communication terminal, an electronic notebook, an electronic book, a portable multimedia player (PMP), a navigation apparatus, and an ultra-mobile personal computer (PC) (UMPC), but also various products, such as televisions, laptop computers, computer monitors, digital billboards, and Internet of things (IoT) apparatuses. Also, the electronic apparatus 1, according to an embodiment, may be used in a wearable apparatus such as a smart watch, a watch phone, a glasses-type display, and a head-mounted display (HMD). Furthermore, the electronic apparatus 1, according to an embodiment, may be used as a display for an instrument panel for a vehicle, a center information display (CID) on a center fascia or dashboard of a vehicle, a room mirror display in lieu of a side-view mirror of a vehicle, or a display arranged on a rear surface of a front seat as an entertainment apparatus for a back seat passenger of a vehicle.

The electronic apparatus 1 may have a substantially rectangular shape in a plan view. For example, the electronic apparatus 1 may have a rectangular planar shape having a pair of short sides extending in an x-direction and a pair of long sides extending in a y-direction, as shown in FIG. 1. A corner where a short side extending in the x-direction and a long side extending in the y-direction meet may be round to have a certain curvature, to form a rounded rectangle, or may be formed at a right angle, to form a standard rectangle. The planar shape of the electronic apparatus 1 is not necessarily limited to a rectangular shape, and the electronic apparatus 1 may have another shape such as a polygonal, a rounded shape such as a circle or an oval, or an irregular shape.

Referring to FIG. 2, the electronic apparatus 1 may include a housing HS and a display apparatus 10. The housing HS may accommodate the display apparatus 10 therein. FIG. 2 illustrates that the housing HS integrally surrounds edges of the display apparatus 10, but is not necessarily limited thereto. In an embodiment, the housing HS may have a shape in which two or more members are combined with each other, rather than being formed as a single body. Also, in addition to the display apparatus 10, components necessary for driving the electronic apparatus 1, for example, a power supply such as a battery, or a circuit board, may be mounted in the housing HS. The housing HS may reliably protect the components of the electronic apparatus 1 accommodated therein from an external impact and from external contamination.

The housing HS may include a rear surface and side surfaces. A cover window 600 may be placed on the front of the housing HS. The housing HS may be combined with the cover window 600. The cover window 600 may be placed on an upper portion of the housing HS.

The display apparatus 10 may include a display area DA and a peripheral area NDA proximate to the display area DA. The display apparatus 10 may provide an image via an array of a plurality of sub-pixels PX arranged in the display area DA. Each sub-pixel PX may include a light-emitting element configured to emit light of a certain color. The light-emitting element may include a light-emitting diode, for example, an organic light-emitting diode (OLED) including an organic emission layer. Hereinafter, it is described that the display apparatus 10 includes an organic light-emitting diode OLED as a light-emitting element, but one or more embodiments are not necessarily limited thereto. In an embodiment, the light-emitting element may be an inorganic light-emitting diode including an inorganic material or a quantum dot light-emitting diode including quantum dots. For example, an emission layer of the light-emitting element may include an organic material, an inorganic material, quantum dots, an organic material and quantum dots, or an inorganic material and quantum dots.

Each sub-pixel PX may emit, for example, red, green, or blue light, or may emit red, green, blue, or white light.

The peripheral area NDA is an area that does not provide an image and may partially or entirely surround the display area DA. Drivers or main power lines configured to provide electrical signals or power to sub-pixel circuits may be arranged in the peripheral area NDA. The peripheral area NDA may include pads which are areas where electronic components or printed circuit boards may be electrically connected.

Referring to FIG. 2, the display apparatus 10 may include a substrate 100, a display layer 200, an encapsulation layer 300, a touch sensor layer 400, an anti-reflection layer 500, an adhesive layer, e.g., an optically clear adhesive, OCA, and a cover window 600.

The substrate 100 may include glass or polymer resin. For example, the polymer resin may include polyethersulfone, polyacrylate, polyether imide, polyethylene naphthalate, polyethylene terephthalate, polyphenylene sulfide, polyarylate, polyimide, polycarbonate, or cellulose acetate propionate. The substrate 100 including the polymer resin may have flexible, rollable or bendable properties. For example, the substrate 100 may be flexed, rolled, or bent, to a noticeable degree, without cracking or otherwise sustaining damage. The substrate 100 may have a multi-layer structure including a layer containing a polymer resin and an inorganic layer.

The display layer 200 may be arranged in the display area DA of the substrate 100. The display layer 200 may include sub-pixels each having a light-emitting element and may display a desired image.

The encapsulation layer 300 may cover the display layer 200. The encapsulation layer 300 may protect the display layer 200 from ambient moisture or oxygen. The encapsulation layer 300 may include at least one inorganic encapsulation layer and at least one organic encapsulation layer.

The touch sensor layer 400 may be disposed on the encapsulation layer 300. The touch sensor layer 400 may detect an external input, such as a touch from an object such as a finger or a stylus pen, and enable the display apparatus 10 to obtain coordinate information corresponding to a location of the touch. The touch sensor layer 400 may include sensor electrodes and detection signal lines connected to the sensor electrodes. The touch sensor layer 400 may sense an external input by using a mutual capacitance method or a self-capacitance method.

The touch sensor layer 400 may be formed directly on the encapsulation layer 300. Alternatively, the touch sensor layer 400 may be formed separately and then attached to the encapsulation layer 300 through an adhesive layer such as an optically clear adhesive layer.

The anti-reflection layer 500 may be disposed on the touch sensor layer 400. The anti-reflection layer 500 may reduce the reflectivity of ambient light incident on the display apparatus 10 from ambient light through the cover window 600. The anti-reflection layer 500 may be a polarizing film including a retarder and/or a polarizer. Alternatively, the anti-reflection layer 500 may include a light-blocking layer and color filters.

The anti-reflection layer 500 may be formed directly on the touch sensor layer 400. Alternatively, the anti-reflection layer 500 may be formed separately and then attached to the touch sensor layer 400 using an adhesive layer such as an optically transparent adhesive layer.

The cover window 600 may be disposed on the anti-reflection layer 500 with an adhesive layer OCA disposed therebetween. The cover window 600 may include a flexible window. For example, the cover window 600 may include a plastic window such as a polyimide window or an ultra-thin glass window.

The cover window 600 may be formed separately and then attached to the anti-reflection layer 500 using the adhesive layer OCA. The adhesive layer OCA may include, for example, an optical clear adhesive. Alternatively, the cover window 600 may be formed directly on the anti-reflection layer 500.

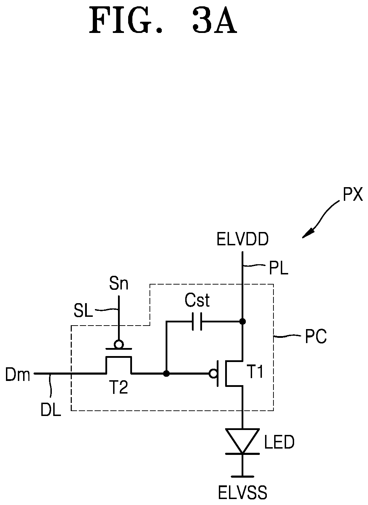

FIG. 3A is an equivalent circuit diagram schematically illustrating a light-emitting element of a display apparatus and a sub-pixel circuit electrically connected to the light-emitting element, according to an embodiment.

Referring to FIG. 3A, a sub-pixel PX may include a sub-pixel circuit PC and a light-emitting element LED electrically connected to the sub-pixel circuit PC. The sub-pixel circuit PC may include a driving transistor T1, a switching transistor T2, and a first storage capacitor Cst.

The switching transistor T2 is electrically connected to a scan line SL and a data line DL and configured to transmit a data signal Dm to the driving transistor T1 according to a scan voltage or a scan signal Sn, wherein the data signal Dm is input through the data line DL, and the scan signal Sn is input through the scan line SL.

The first storage capacitor Cst is electrically connected to the switching transistor T2 and a driving voltage line PL, and may store a voltage corresponding to a difference between a voltage received from the switching transistor T2 and a driving voltage ELVDD supplied to the driving voltage line PL.

The driving transistor T1 may be connected to the driving voltage line PL and the first storage capacitor Cst and configured to control a driving current according to the voltage stored in the first storage capacitor Cst, the driving current flowing from the driving voltage line PL to the light-emitting element LED. The light-emitting element LED may be configured to emit light of certain luminance in response to the driving current. A sub-pixel electrode (e.g., an anode) of the light-emitting element LED is electrically connected to the sub-pixel circuit PC, and an opposite electrode (e.g., a cathode) of the light-emitting element LED may be supplied with a common voltage ELVSS.

Although FIG. 3A illustrates that the sub-pixel circuit PC includes two transistors and one storage capacitor, it is to be understood that in other embodiments, the number of transistors or the number of storage capacitors may vary depending on the design of the sub-pixel circuit PC.

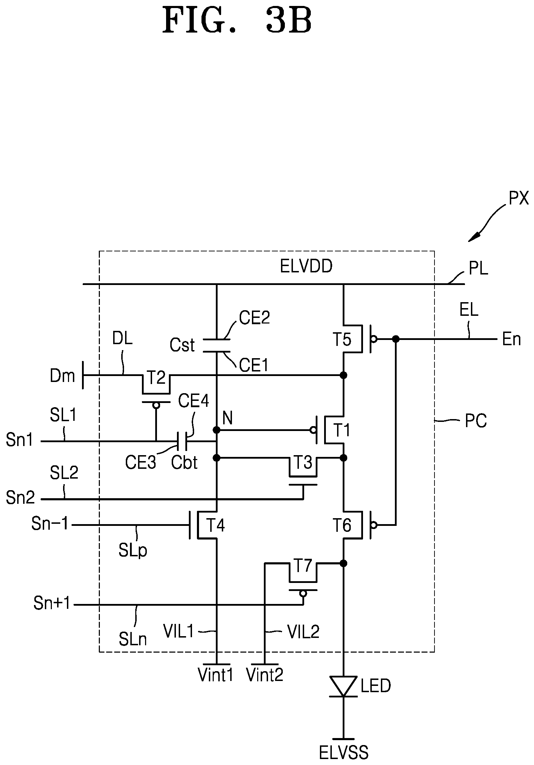

FIG. 3B is an equivalent circuit diagram schematically illustrating a light-emitting element of a display apparatus and a sub-pixel circuit electrically connected to the light-emitting element, according to an embodiment.

Referring to FIG. 3B, the sub-pixel circuit PC may include transistors T1 to T7, a first storage capacitor Cst, and a second storage capacitor Cbt. The transistors T1 to T7, the first storage capacitor Cst and the second storage capacitor Cbt may be connected to signal lines, a first initialization voltage line VIL1, a second initialization voltage line VIL2, and a driving voltage line PL. In an embodiment, at least one of the signal lines, the first and second initialization voltage lines VIL1 and VIL2 and/or the driving voltage line PL may be shared by neighboring sub-pixels PX.

In an embodiment, the transistors T1 to T7 may include a driving transistor T1, a switching transistor T2, a compensation transistor T3, a first initialization transistor T4, an operation control transistor T5, an emission control transistor T6, and a second initialization transistor T7. However, one or more embodiments are not limited thereto.

The light-emitting element LED may include a sub-pixel electrode and an opposite electrode, and the sub-pixel electrode of the light-emitting element LED may be electrically connected to the driving transistor T1 via the emission control transistor T6 to receive a driving current, and the opposite electrode may be provided with a common voltage ELVSS. The light-emitting diode LED may produce light with a brightness corresponding to the driving current. In an embodiment, the light-emitting element LED may be an organic light-emitting diode (OLED) including an organic emission layer.

The driving voltage line PL may be configured to transmit the driving voltage ELVDD to the driving transistor T1. The first initialization voltage line VIL1 may be configured to transmit, to the sub-pixel circuit PC, a first initialization voltage Vint1 that initializes the driving transistor T1. The second initialization voltage line VIL2 may be configured to transmit, to the sub-pixel circuit PC, a second initialization voltage Vint2 that initializes the light-emitting element LED.

In an embodiment, among the driving transistor T1, the switching transistor T2, the compensation transistor T3, the first initialization transistor T4, the operation control transistor T5, the emission control transistor T6, and the second initialization transistor T7, the compensation transistor T3 and the first initialization transistor T4 may be implemented as NMOS (n-channel MOSFETs), and the remaining transistors may be implemented as PMOS (p-channel MOSFETs).

A drain region of the driving transistor T1 may be electrically connected to the light-emitting element LED via the emission control transistor T6. The driving transistor T1 may receive a data signal Dm according to a switching operation of the switching transistor T2 and supply the driving current to the light-emitting element LED.

The switching transistor T2 may be turned on in response to a first scan signal Sn1 received from a first scan line SL1 and perform the switching operation of transmitting the data signal Dm, which is received from the data line DL, to a source region of the driving transistor T1.

A gate electrode of the compensation transistor T3 may be electrically connected to a second scan line SL2. A source region of the compensation transistor T3 is electrically connected to the drain region of the driving transistor T1 and may be electrically connected to the sub-pixel electrode of the light-emitting element LED via the emission control transistor T6. A drain region of the compensation transistor T3 may be electrically connected to one electrode of the first storage capacitor Cst, a source region of the first initialization transistor T4, and a gate electrode of the driving transistor T1. The compensation transistor T3 may be turned on according to the second scan signal Sn2 received through the second scan line SL2 to electrically connect the gate electrode and the drain region of the driving transistor T1 to diode-connect the driving transistor T1.

A gate electrode of the first initialization transistor T4 may be electrically connected to a previous scan line SLp. A drain region of the first initialization transistor T4 may be electrically connected to the first initialization voltage line VIL1. A source region of the first initialization transistor T4 may be electrically connected to one electrode of the first storage capacitor Cst, the drain region of the compensation transistor T3, and the gate electrode of the driving transistor T1. The first initialization transistor T4 may be turned on according to a previous scan signal Sn-1 received through the previous scan line SLp and perform an initialization operation of transmitting the first initialization voltage Vint1 to the gate electrode of the driving transistor T1 to initialize a voltage of the gate electrode of the driving transistor T1.

A gate electrode of the second initialization transistor T7 may be electrically connected to a next scan line SLn. A source region of the second initialization transistor T7 may be electrically connected to the sub-pixel electrode of the light-emitting element LED. A drain region of the second initialization transistor T7 may be electrically connected to the second initialization voltage line VIL2. The second initialization transistor T7 may be turned on according to a next scan signal Sn+1 received through the next scan line SLn to initialize the sub-pixel electrode of the light-emitting element LED.

The first storage capacitor Cst may include a first capacitor electrode CE1 and a second capacitor electrode CE2. The first capacitor electrode CE1 may be electrically connected to the gate electrode of the driving transistor T1, and the second capacitor electrode CE2 may be electrically connected to the driving voltage line PL. The first storage capacitor Cst may be configured to maintain a voltage applied to the gate electrode of the driving transistor T1 by storing and maintaining a voltage corresponding to a difference between the driving voltage ELVDD supplied to the driving voltage line PL and a voltage of the gate electrode of the driving transistor T1.

The second storage capacitor Cbt may include a third capacitor electrode CE3 and a fourth capacitor electrode CE4. The third capacitor electrode CE3 may be electrically connected to the first scan line SL1 and the gate electrode of the switching transistor T2. The fourth capacitor electrode CE4 may be electrically connected to the gate electrode of the driving transistor T1 and the first capacitor electrode CE1 of the first storage capacitor Cst. The second storage capacitor Cbt may be a boosting capacitor that increases a voltage of a node N and reduces a voltage indicating black (black voltage) when the first scan signal Sn1 of the first scan line SL1 is a voltage that turns off the switching transistor T2.

An example operation of the sub-pixel circuit PC according to an embodiment is described in detail below.

During a first initialization period, when the previous scan signal Sn-1 is supplied through the previous scan line SLp, the first initialization transistor T4 is turned on in response to the previous scan signal Sn-1, and the driving transistor T1 may be initialized by the first initialization voltage Vint1 supplied from the first initialization voltage line VIL1.

During a data programming period, when the first scan signal Sn1 and the second scan signal Sn2 are supplied through the first scan line SL1 and the second scan line SL2, respectively, the switching transistor T2 and the compensation transistor T3 may be turned on in response to the first scan signal Sn1 and the second scan signal Sn2. Here, the driving transistor T1 is diode-connected by the compensation transistor T3 which is turned on, and the driving transistor T1 may be forward-biased. Then, a compensation voltage in which the threshold voltage (Vth) of the driving transistor T1 is compensated for by the data signal Dm supplied from the data line DL may be applied to the gate electrode of the driving transistor T1. The driving voltage ELVDD and the compensation voltage are respectively applied to two ends of the first storage capacitor Cst, and a charge corresponding to the voltage difference between the two ends may be stored in the first storage capacitor Cst.

During an emission period, the operation control transistor T5 and the emission control transistor T6 may be turned on by an emission control signal En supplied from an emission control line EL. A driving current may be generated according to the voltage difference between the voltage of the gate electrode of the driving transistor T1 and the driving voltage ELVDD, and the driving current may be supplied to the light-emitting element LED through the emission control transistor T6.

During a second initialization period, when the next scan signal Sn+1 is supplied through the next scan line SLn, the second initialization transistor T7 is turned on in response to the next scan signal Sn+1, and the light-emitting element LED may be initialized by the second initialization voltage Vint2 supplied from the second initialization voltage line VIL2.

In an embodiment, at least one of the transistors T1 to T7 may be provided as an oxide-based transistor including an oxide semiconductor, and the remaining transistors may be provided as silicon-based transistors including a silicon semiconductor.

For example, in a case of the driving transistor T1 that directly affects the brightness of the display apparatus, the driving transistor T1 may include a semiconductor layer including polycrystalline silicon having high reliability, and thus, a high-resolution display apparatus may be implemented.

Because oxide semiconductors have high carrier mobility and low leakage current, the voltage drop of transistors that include oxide semiconductors might not be large even if the driving time is long. For example, because the color change of the image caused by the voltage drop is not large even when the display apparatus is operated at low frequencies, a low-frequency operation is possible.

Because oxide semiconductors have a low leakage current, at least one of the compensation transistor T3, the first initialization transistor T4, and the second initialization transistor T7, which is electrically connected to the gate electrode of the driving transistor T1, may include an oxide semiconductor layer. Therefore, leakage current that may flow to the gate electrode of the driving transistor T1 may be prevented while reducing power consumption.

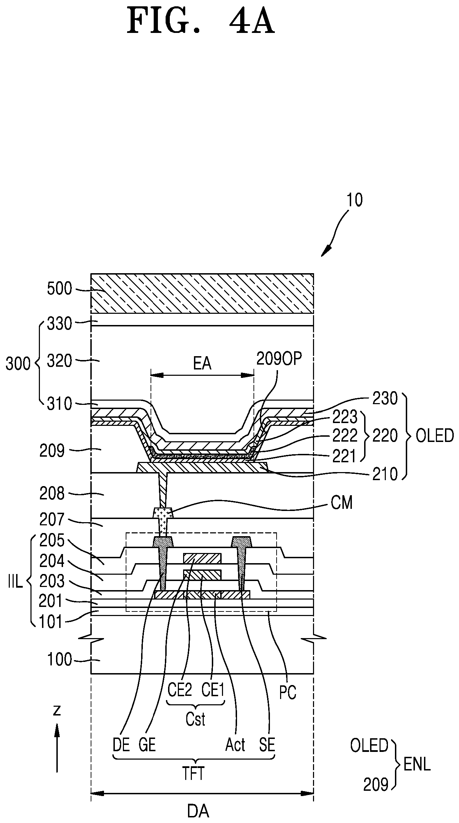

FIG. 4A is a cross-sectional view schematically illustrating a display area of a display apparatus of FIG. 1, according to an embodiment.

Referring to FIG. 4A, an organic light-emitting diode OLED as a light-emitting element and a sub-pixel circuit PC electrically connected to the organic light-emitting diode OLED may be arranged in the display area DA of the substrate 100.

A buffer layer 201 may be disposed on the substrate 100, may reduce or block penetration of foreign materials, moisture, or ambient air from below the substrate 100, and provide a flat surface on the substrate 100. The buffer layer 201 may include an inorganic material, an organic material, or an organic/inorganic composite material and include a single layer or a multi-layer including an inorganic material and an organic material, the inorganic material including oxide or nitride.

A barrier layer 101 may be further disposed between the substrate 100 and the buffer layer 201, the barrier layer 101 blocking penetration of ambient air. In an embodiment, the buffer layer 201 may include silicon oxide or silicon nitride.

The sub-pixel circuit PC may be disposed on the buffer layer 201, wherein the sub-pixel circuit PC includes a thin-film transistor TFT and a first storage capacitor Cst. The thin-film transistor TFT may include a semiconductor layer Act, a gate electrode GE, a drain electrode DE, and a source electrode SE. In an embodiment, the thin-film transistor TFT may be a driving transistor.

The semiconductor layer Act may be disposed on the buffer layer 201 and may include polycrystalline silicon. In an embodiment, the semiconductor layer Act may include amorphous silicon. In an embodiment, the semiconductor layer Act may include an oxide of at least one of indium (In), gallium (Ga), tin (Sn), zirconium (Zr), vanadium (V), hafnium (Hf), cadmium (Cd), germanium (Ge), chromium (Cr), titanium (Ti), and zinc (Zn). The semiconductor layer Act may include a channel region, a source region, and a drain region, the source region and the drain region being doped with impurities.

A first gate insulating layer 203 may cover the semiconductor layer Act. The first gate insulating layer 203 may include an inorganic insulating material such as silicon oxide, silicon nitride, silicon oxynitride, aluminium oxide, titanium oxide, tantalum oxide, hafnium oxide, or zinc oxide. The first gate insulating layer 203 may include a single layer or a multi-layer including the inorganic insulating material.

The gate electrode GE may be disposed on the first gate insulating layer 203 to overlap the semiconductor layer Act. The gate electrode GE may include at least one of molybdenum (Mo), aluminium (Al), copper (Cu), titanium (Ti) and the like and include a single layer or a multi-layer. For example, the gate electrode GE may include a single Mo layer.

A second gate insulating layer 204 may cover the gate electrode GE. The second gate insulating layer 204 may include an inorganic insulating material such as silicon oxide, silicon nitride, silicon oxynitride, aluminium oxide, titanium oxide, tantalum oxide, hafnium oxide, or zinc oxide. The second gate insulating layer 204 may include a single layer or a multi-layer including the inorganic insulating material.

A second capacitor electrode CE2 of the first storage capacitor Cst may be disposed on the second gate insulating layer 204. The second capacitor electrode CE2 may overlap the gate electrode GE. The gate electrode GE and the second capacitor electrode CE2 overlapping each other with the second gate insulating layer 204 therebetween may form the first storage capacitor Cst. For example, the gate electrode GE may serve as a first capacitor electrode CE1 of the first storage capacitor Cst.

The second capacitor electrode CE2 may include aluminium (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu) and include a single layer or a multi-layer including the above materials.

An interlayer insulating layer 205 may cover the second capacitor electrode CE2. The interlayer insulating layer 205 may include an inorganic insulating material such as silicon oxide, silicon nitride, silicon oxynitride, aluminium oxide, titanium oxide, tantalum oxide, hafnium oxide, or zinc oxide. The interlayer insulating layer 205 may include a single layer or a multi-layer including the inorganic insulating material.

The barrier layer 101, the buffer layer 201, the first gate insulating layer 203, the second gate insulating layer 204, and the interlayer insulating layer 205 may be referred to as inorganic insulating layers IIL.

The source electrode SE and the drain electrode DE are disposed on the interlayer insulating layer 205. The source electrode SE and the drain electrode DE may each include an electrically conductive material including molybdenum (Mo), aluminium (Al), copper (Cu), and titanium (Ti) and include a single layer or a multi-layer including the above materials. For example, the source electrode SE and the drain electrode DE may have a multi-layer structure of Ti/Al/Ti. In an embodiment, the source electrode SE or the drain electrode DE may be omitted. For example, adjacent thin-film transistors TFT may be configured to share the source region or the drain region of the semiconductor layer Act. The source region or the drain region may serve as the source electrode SE or the drain electrode DE.

A first organic insulating layer 207 and a second organic insulating layer 208 may be sequentially arranged to cover the source electrode SE and the drain electrode DE. The second organic insulating layer 208 may have a flat upper surface such that a sub-pixel electrode 210 disposed thereon is formed flat.

The first organic insulating layer 207 and the second organic insulating layer 208 may each include an organic material. The first organic insulating layer 207 and the second organic insulating layer 208 may include an organic insulating material such as a general-purpose polymer such as benzocyclobutene (BCB), polyimide, hexamethyldisiloxane (HMDSO), polymethylmethacrylate (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, or a vinyl alcohol-based polymer. When forming the first organic insulating layer 207 and the second organic insulating layer 208, to provide a flat upper surface after forming the layers, chemical mechanical polishing may be performed on the upper surface of the layers.

A connection electrode CM may be disposed on the first organic insulating layer 207. The first organic insulating layer 207 may include a contact hole exposing one of the source electrode SE and the drain electrode DE of the thin-film transistor TFT, and the connection electrode CM may be electrically connected to the thin-film transistor TFT by being in contact with the source electrode SE or the drain electrode DE through the contact hole.

The connection electrode CM may include an electrically conductive material including molybdenum (Mo), aluminium (Al), copper (Cu), and titanium (Ti) and have a single-layer structure or a multi-layer structure including the above materials.

A light-emitting element layer ENL may be disposed on the second organic insulating layer 208. The light-emitting element layer ENL may include the organic light-emitting diode OLED as the light-emitting element and a first bank layer 209. The organic light-emitting diode OLED may include a sub-pixel electrode 210, an intermediate layer 220, and an opposite electrode 230.

The sub-pixel electrode 210 may be disposed on the second organic insulating layer 208. The second organic insulating layer 208 may include a contact hole exposing the connection electrode CM, and the sub-pixel electrode 210 may be electrically connected to the thin-film transistor TFT by being in contact with the connection electrode CM through the contact hole.

The sub-pixel electrode 210 may include an electrically conductive oxide such as indium tin oxide (ITO), indium zinc oxide (IZO), zinc oxide (ZnO), indium oxide (In₂O₃), indium gallium oxide (IGO), or aluminium zinc oxide (AZO). The sub-pixel electrode 210 may include a reflective layer including silver (Ag), magnesium (Mg), aluminium (Al), platinum (Pt), palladium (Pd), gold (Au), nickel (Ni), neodymium (Nd), iridium (Ir), chromium (Cr), or a compound thereof. For example, the sub-pixel electrode 210 may have a structure including layers on/under the reflective layer, the layers including ITO, IZO, ZnO, or In₂O₃. In this case, the sub-pixel electrode 210 may have a stack structure of ITO/Ag/ITO.

The first bank layer 209 on the second organic insulating layer 208 may cover the edges of the sub-pixel electrode 210 and have an opening 209OP exposing the central portion of the sub-pixel electrode 210. An emission area EA of the organic light-emitting diode OLED, for example, the size and shape of the sub-pixel, may be defined by the opening 209OP.

The first bank layer 209 may prevent electrical arcing and the like from occurring at the edges of the sub-pixel electrode 210 by increasing a distance between the edges of the sub-pixel electrode 210 and the opposite electrode 230 over the sub-pixel electrode 210. The first bank layer 209 may include an organic insulating material such as polyamide, acryl resin, benzocyclobutene, and hexamethyldisiloxane (HMDSO) and be formed by spin coating and the like.

The first bank layer 209 may be black. The first bank layer 209 may include a light-blocking material and may be provided in black. The light-blocking material may include carbon black, carbon nanotubes, resin or paste including black dye, particles of a metal, for example, nickel (Ni), aluminium (Al), molybdenum (Mo), or an alloy thereof, particles of a metal oxide (e.g., chromium oxide), or particles of a metal nitride (e.g., chromium nitride). In a case where the first bank layer 209 includes a light-blocking material, ambient light reflection by metal structures disposed below the first bank layer 209 may be reduced.

The intermediate layer 220 may include an emission layer 222, a first functional layer 221, and a second functional layer 223. The emission layer 222 may be arranged in the opening 209OP of the first bank layer 209, wherein the emission layer 222 is formed to correspond to the sub-pixel electrode 210. The emission layer 222 may include a polymer material or a low-molecular weight material and be configured to emit red, green, blue, or white light.

The first functional layer 221 and the second functional layer 223 may be respectively disposed under and/or on the emission layer 222. In an embodiment, unlike the emission layer 222 patterned for each sub-pixel, the first functional layer 221 and the second functional layer 223 may be integrally provided entirely in the display area DA.

The first functional layer 221 may include a single layer or a multi-layer. For example, in a case where the first functional layer 221 includes a polymer material, the first functional layer 221 may include a hole transport layer (HTL), which has a single-layer structure, and may include poly-(3,4)-ethylene-dihydroxy thiophene (PEDOT) or polyaniline (PANI). In a case where the first functional layer 221 includes a low-molecular weight material, the first functional layer 221 may include a hole injection layer (HIL) and an HTL.

The second functional layer 223 may be omitted. For example, the second functional layer 223 may be formed when the first functional layer 221 and the emission layer 222 include a polymer material. The second functional layer 223 may include a single layer or a multi-layer. The second functional layer 223 may include an electron transport layer (ETL) and/or an electron injection layer (EIL). In an embodiment, at least one of an HIL, an HTL, an ETL, and an EIL may be omitted.

The opposite electrode 230 may include an electrically conductive material having a relatively low work function. For example, the opposite electrode 230 may include a transparent or semitransparent layer including silver (Ag), magnesium (Mg), aluminium (Al), nickel (Ni), chromium (Cr), lithium (Li), calcium (Ca), or an alloy thereof. Also, the opposite electrode 230 may further include a layer on the transparent or semitransparent layer, the layer including ITO, IZO, ZnO, or In₂O₃. In an embodiment, the opposite electrode 230 may include silver (Ag) and magnesium (Mg). A stack structure of the sub-pixel electrode 210, the intermediate layer 220, and the opposite electrode 230 that are sequentially stacked may form the organic light-emitting diode OLED.

In an embodiment, a capping layer may be disposed on the organic light-emitting diode OLED. The capping layer may be configured to increase the light-emission efficiency of the organic light-emitting diode OLED based on a constructive interference principle. The capping layer may include an organic capping layer including an organic material, an inorganic capping layer including an inorganic material, or a composite capping layer including an organic material and an inorganic material.

The encapsulation layer 300 may be disposed on the organic light-emitting diode OLED. In an embodiment, the encapsulation layer 300 may include at least one inorganic encapsulation layer and at least one organic encapsulation layer. The encapsulation layer 300 may include a first inorganic encapsulation layer 310, a second inorganic encapsulation layer 330 disposed on the first inorganic encapsulation layer 310, and an organic encapsulation layer 320 disposed between the first inorganic encapsulation layer 310 and the second inorganic encapsulation layer 330.

Each of the first and second inorganic encapsulation layers 310 and 330 may include at least one inorganic insulating material. The inorganic insulating material may include aluminium oxide, titanium oxide, tantalum oxide, hafnium oxide, zinc oxide, silicon oxide, silicon nitride, and/or silicon oxynitride. The first and second inorganic encapsulation layers 310 and 330 may be formed by using chemical vapor deposition.

The organic encapsulation layer 320 may include an organic insulating material. The organic insulating material may include polyethylene terephthalate, polyethylene naphthalate, polycarbonate, polyimide, polyethylene sulfonate, polyoxymethylene, polyarylate, hexamethyldisiloxane, acrylic resin (e.g., polymethyl methacrylate or polyacrylic acid), or a combination thereof.

The encapsulation layer 300 may cover the entire display area DA and may extend to the peripheral area NDA to cover at least a portion of the peripheral area NDA.

The anti-reflection layer 500 may be disposed on the encapsulation layer 300. In an embodiment, the anti-reflection layer 500 may be a polarizing film. In an embodiment, the anti-reflection layer 500 may be disposed directly on the encapsulation layer 300. The anti-reflection layer 500 may be in direct contact with the second inorganic encapsulation layer 330.

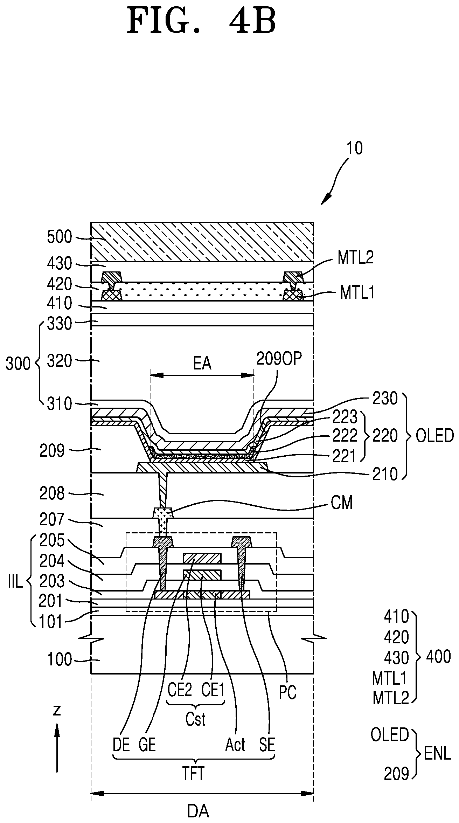

FIG. 4B is a cross-sectional view schematically illustrating a portion of a display area of a display apparatus, according to an embodiment. FIG. 4B is a modified embodiment of FIG. 4A, and to the extent that an element is not described in detail with respect to this figure, it may be understood that the element is at least similar to a corresponding element that has been described elsewhere within the present disclosure.

Referring to FIG. 4B, the organic light-emitting diode OLED as the light-emitting element and the sub-pixel circuit PC electrically connected to the organic light-emitting diode OLED may be arranged in the display area DA of the substrate 100.

The encapsulation layer 300 may cover the organic light-emitting diode OLED. The encapsulation layer 300 may include the first inorganic encapsulation layer 310, the organic encapsulation layer 320, and the second inorganic encapsulation layer 330.

The touch sensor layer 400 may be disposed on the encapsulation layer 300. The touch sensor layer 400 may have a multi-layer structure. The touch sensor layer 400 may include a sensor electrode, a detection signal line (e.g., trace signal line) connected to the sensor electrode, and at least one insulating layer. The touch sensor layer 400 may detect an external input by using, for example, a capacitive method. An operation method of the touch sensor layer 400 is not necessarily limited thereto, and in some embodiments, the touch sensor layer 400 may detect an external input by using an electromagnetic induction method or a pressure sensing method.

The touch sensor layer 400 may include a first touch insulating layer 410, a first touch conductive layer MTL1, a second touch insulating layer 420, a second touch conductive layer MTL2, and a third touch insulating layer 430.

The first touch insulating layer 410 may be disposed directly on the encapsulation layer 300. The first touch insulating layer 410 may include an inorganic material or an organic material and may have a single or multi-layer structure. The organic material may include at least one of an acryl-based resin, a methacryl-based resin, a polyisoprene, a vinyl-based resin, an epoxy-based resin, a urethane-based resin, a cellulose-based resin, and a perylene-based resin. The inorganic material may include at least one of silicon nitride, aluminium nitride, zirconium nitride, titanium nitride, hafnium nitride, tantalum nitride, silicon oxide, aluminium oxide, titanium oxide, tin oxide, cerium oxide, and silicon oxynitride.

The first touch insulating layer 410 may prevent damage to the encapsulation layer 300 and may block an interference signal that may occur when the touch sensor layer 400 is driven.

Each of the first touch conductive layer MTL1 and the second touch conductive layer MTL2 may include a metal layer or a transparent conductive layer. The metal layer may include molybdenum (Mo), silver (Ag), titanium (Ti), copper (Cu), aluminium (Al), or an alloy thereof. The transparent conductive layer may include a transparent conductive oxide such as indium tin oxide (ITO), indium zinc oxide (IZO), zinc oxide (ZnO), or indium tin zinc oxide (ITZO). Each of the first touch conductive layer MTL1 and the second touch conductive layer MTL2 may include a single-layer structure or a multi-layer structure. For example, each of the first touch conductive layer MTL1 and the second touch conductive layer MTL2 may have a three-layer structure including Ti/Al/Ti.

Each of the first touch conductive layer MTL1 and the second touch conductive layer MTL2 may include a plurality of patterns. The first touch conductive layer MTL1 may include first conductive patterns, and the second touch conductive layer MTL2 may include second conductive patterns. The first conductive patterns and the second conductive patterns may form the sensor electrode.

The first touch conductive layer MTL1 and the second touch conductive layer MTL2 may be electrically connected to each other through a contact hole. In an embodiment, the first touch conductive layer MTL1 and the second touch conductive layer MTL2 may have a mesh structure through which light emitted from the organic light-emitting diode OLED passes. In this case, the first touch conductive layer MTL1 and the second touch conductive layer MTL2 might not overlap the emission area EA.

The second touch insulating layer 420 may include an inorganic material or an organic material. The organic material may include at least one of an acryl-based resin, a methacryl-based resin, a polyisoprene, a vinyl-based resin, an epoxy-based resin, a urethane-based resin, a cellulose-based resin, and a perylene-based resin. The inorganic material may include at least one of silicon nitride, aluminium nitride, zirconium nitride, titanium nitride, hafnium nitride, tantalum nitride, silicon oxide, aluminium oxide, titanium oxide, tin oxide, cerium oxide, and silicon oxynitride.

The third touch insulating layer 430 may be disposed on the second touch conductive layer MTL2. The third touch insulating layer 430 may have a single or multi-layer structure. The third touch insulating layer 430 may include an organic material, an inorganic material, or a composite material. The inorganic material may include at least one of silicon nitride, aluminium nitride, zirconium nitride, titanium nitride, hafnium nitride, tantalum nitride, silicon oxide, aluminium oxide, titanium oxide, tin oxide, cerium oxide, and silicon oxynitride. The organic material may include at least one of an acryl-based resin, a methacryl-based resin, a polyisoprene, a vinyl-based resin, an epoxy-based resin, a urethane-based resin, a cellulose-based resin, and a perylene-based resin.

The anti-reflection layer 500 may be disposed on the encapsulation layer 300. In an embodiment, the anti-reflection layer 500 may be a polarizing film. In an embodiment, the anti-reflection layer 500 may be disposed directly on the touch sensor layer 400. The anti-reflection layer 500 may be in direct contact with the insulating layer of the touch sensor layer 400, for example, the third touch insulating layer 430.

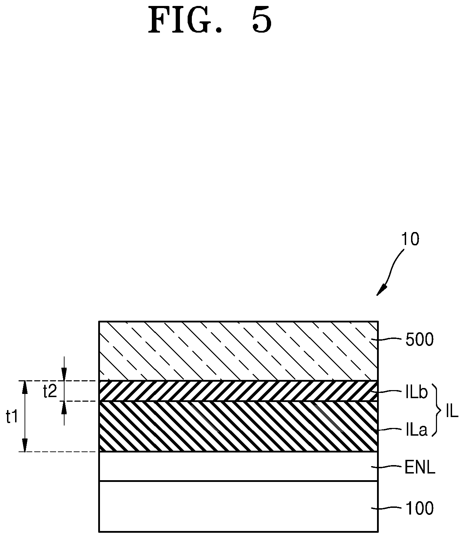

FIG. 5 is a cross-sectional view schematically illustrating a portion of a display apparatus, according to an embodiment. In a stack structure of FIG. 5, some additional layers may be included in the display apparatus.

Referring to FIG. 5, an inorganic layer IL may be disposed between the substrate 100 and the anti-reflection layer 500. The inorganic layer IL may be disposed between the light-emitting element layer ENL and the anti-reflection layer 500. FIG. 5 illustrates that the inorganic layer IL is directly disposed on the light-emitting element layer ENL, but an embodiment is not necessarily limited thereto. In an embodiment, the anti-reflection layer 500 may be disposed directly on the inorganic layer IL. The anti-reflection layer 500 may be in direct contact with an upper surface of the inorganic layer IL.

The inorganic layer IL may be the second inorganic encapsulation layer 330 (see FIG. 4A) of the encapsulation layer 300 (see FIG. 4A) and/or an insulating layer of the touch sensor layer 400 (see FIG. 4B). For example, the insulating layer of the touch sensor layer 400 may be a third touch insulating layer 430 (see FIG. 4B). In this case, the anti-reflection layer 500 may be in direct contact with the upper surface of the inorganic layer IL. The anti-reflection layer 500 may be a polarizing film.

The inorganic layer IL may include an inorganic insulating material. The inorganic layer IL may include a nitride. In an embodiment, the inorganic layer IL may include silicon nitride.

The inorganic layer IL may be formed by chemical vapor deposition. For example, the inorganic layer IL may be formed by plasma chemical vapor deposition. In an embodiment, the inorganic layer IL may be formed by a low temperature deposition process of about 100 °C or lower. For example, the inorganic layer IL may be formed by a low-temperature and low-power deposition process. When the inorganic layer IL is deposited under low power and/or low temperature conditions, damage to the organic layer under the inorganic layer IL caused by the plasma may be reduced. For example, when the inorganic layer IL is the second inorganic encapsulation layer 330 of the encapsulation layer 300, damage to the organic encapsulation layer 320 under the second inorganic encapsulation layer 330 may be prevented.

At least a portion of the inorganic layer IL may have a compressive stress, for example, the material of the inorganic layer IL may be deposited or processed such that its internal structure has a tendency to compress, for example, by chemical vapor deposition (CVD) under positive pressure, physical vapor deposition (PVD) such as sputtering while using a high gas pressure, or by a thermal process where a film is deposited at a high temperature and then allowed to cool down. However, other techniques that are known in the art for producing a layer with compressive stress may be used such as ion implantation/bombardment, layer compression, plasma treatment, etc.

A compressive stress of at least a portion of the inorganic layer IL may be about 200 MPa or greater. In an embodiment, a compressive stress of the at least a portion of the inorganic layer IL may be about 200 MPa to about 400 MPa. In an embodiment, a compressive stress of the at least a portion of the inorganic layer IL may be about 250 MPa to about 400 MPa.

At least a portion of the inorganic layer IL may be a portion including the upper surface of the inorganic layer IL. A compressive stress may be an indicator of the degree of internal defects in the inorganic layer IL. For example, a high compressive stress may indicate a small degree of internal defects in the inorganic layer IL. When the compressive stress of at least a portion of the inorganic layer IL is about 200 MPa or greater, the portion may have small internal defects and a number of dangling bonds in the portion may be reduced. However, when the compressive stress of at least a portion of the inorganic layer IL exceeds about 400 MPa, the stress of the inorganic layer IL may increase excessively, and defects such as film lifting may occur.

Referring to FIG. 5, the inorganic layer IL may be provided with multiple layers. For example, the inorganic layer IL may include a first layer ILa and a second layer ILb disposed on the first layer ILa. The second layer ILb is disposed on the uppermost portion of the inorganic layer IL and may include the upper surface of the inorganic layer IL. In an embodiment, when the anti-reflection layer 500 is in direct contact with the inorganic layer IL, the second layer ILb may form an interface with the anti-reflection layer 500.

In an embodiment, a compressive stress of the second layer ILb may be different from a compressive stress of the first layer ILa. The compressive stress of the second layer ILb may be greater than the compressive stress of the first layer ILa. A compressive stress of the second layer ILb may be about 200 MPa or greater. In an embodiment, a compressive stress of the second layer ILb may be about 200 MPa to about 400 MPa. In an embodiment, a compressive stress of the second layer ILb may be about 250 MPa to about 400 MPa. In contrast, a compressive stress of the first layer ILa may be lower than about 200 MPa. When the compressive stress of the second layer ILb is about 200 MPa or greater, the degree of internal defects in the second layer ILb may be reduced, and the number of dangling bonds in the second layer ILb may be reduced.

In an embodiment, a density of the second layer ILb may be different from a density of the first layer ILa. The density of the second layer ILb may be greater than the density of the first layer ILa. The density of the second layer ILb may be about 2.0 g/cm³ or greater. In an embodiment, the density of the second layer ILb may be about 2.0 g/cm³ to about 2.5 g/cm³. The density of the first layer ILa may be lower than about 2.0 g/cm³.

In an embodiment, a thickness t2 of the second layer ILb may be about 10% to about 15% of a total thickness t1 of the inorganic layer IL. When the thickness t2 of the second layer ILb is lower than about 10% of the total thickness t1 of the inorganic layer IL, the effect of improving internal defects and oxidation level of the uppermost portion of the inorganic layer IL may be insignificant. When the thickness t2 of the second layer ILb exceeds about 15% of the total thickness t1 of the inorganic layer IL, the stress of the entire inorganic layer IL increases, which may cause a film lifting phenomenon of the inorganic layer IL. When the thickness t2 of the second layer ILb is about 10% to about 15% of the total thickness t1 of the inorganic layer IL, the internal defects of the second layer ILb corresponding to the uppermost portion of the inorganic layer IL are reduced and the density of the second layer ILb is increased, while the stress of the entire inorganic layer IL is not excessively increased, thereby preventing the film lifting phenomenon of the inorganic layer IL.

As a comparative example, an inorganic layer may be deposited by a low-temperature plasma CVD process to protect an organic layer under the inorganic layer, and thus, the inorganic layer may have many internal defects. When a compressive stress of the entire inorganic layer is lower than about 200 MPa, internal defects of the entire inorganic layer may be large and a number of dangling bonds of the entire inorganic layer may be large. In this case, the inorganic layer may be susceptible to oxidation in high temperature and high humidity environments. In addition, ammonia (NH₃) gas present near the unbound site among the gases that form silicon nitride, which is a component of the inorganic layer, may react with the iodine (I-) component of an anti-reflection layer (e.g., polarizing film) disposed on the upper portion of the inorganic layer and discolor the anti-reflection layer. Therefore, a defect of a display apparatus may occur. The reliability of the display apparatus may be reduced.

However, according to one or more embodiments, when the uppermost portion of the inorganic layer IL, for example, the second layer ILb, has a compressive stress of about 200 MPa or greater, internal defects in the uppermost portion of the inorganic layer IL may be reduced and the number of dangling bonds in the uppermost portion of the inorganic layer IL may be reduced. In this case, the uppermost portion of the inorganic layer IL may have improved oxidation in a high temperature and high humidity environment. Because the unbound sites in the uppermost portion of the inorganic layer IL in contact with the anti-reflection layer 500 are reduced, the discoloration of the anti-reflection layer caused by the reaction between ammonia (NH₃) gas and the iodine (I-) component of the anti-reflection layer (e.g., polarizing film) may be reduced. Therefore, the reliability of the display apparatus may be increased.

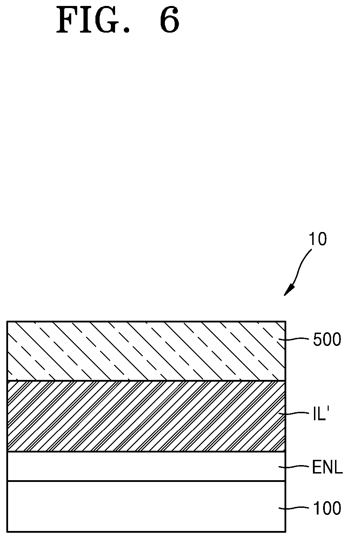

FIG. 6 is a cross-sectional view schematically illustrating a portion of a display apparatus, according to an embodiment. In a stack structure of FIG. 6, some layers included in the display apparatus might not be illustrated. FIG. 6 is a modified embodiment of FIG. 5, and to the extent that an element is not described in detail with respect to this figure, it may be understood that the element is at least similar to a corresponding element that has been described elsewhere within the present disclosure.

An inorganic layer IL' may be disposed between the light-emitting element layer ENL and the anti-reflection layer 500 on the substrate 100.

Similar to FIG. 5, the inorganic layer IL' may be the second inorganic encapsulation layer 330 (see FIG. 4A) of the encapsulation layer 300 (see FIG. 4A) and/or an insulating layer of the touch sensor layer 400 (see FIG. 4B). For example, the insulating layer of the touch sensor layer 400 may be a third touch insulating layer 430 (see FIG. 4B). In this case, the anti-reflection layer 500 may be in direct contact with an upper surface of the inorganic layer IL'. The anti-reflection layer 500 may be a polarizing film.

The inorganic layer IL' may include a nitride. In an embodiment, the inorganic layer IL' may include silicon nitride. A compressive stress of the entire inorganic layer IL' may be about 200 MPa or greater. In an embodiment, a compressive stress of the entire inorganic layer IL' may be about 200 MPa to about 400 MPa. In an embodiment, a compressive stress of the entire inorganic layer IL' may be about 250 MPa to about 400 MPa. The number of internal defects and dangling bonds of the entire inorganic layer IL' may be small. A density of the entire inorganic layer IL' may be about 2.0 g/cm³ or greater. In an embodiment, the density of the entire inorganic layer IL' may be about 2.0 g/cm³ to about 2.5 g/cm³.

In this case, internal defects and dangling bonds are reduced at an interface of the inorganic layer IL' in contact with the anti-reflection layer 500, and thus, oxidation of the inorganic layer IL' in a high temperature and high humidity environment may be reduced. The reactivity of the inorganic layer IL' and the iodine (I-) component in the anti-reflection layer 500 may be reduced.

Compared to the inorganic layer IL of FIG. 5 that includes multiple layers having different compressive stresses, the inorganic layer IL' may be deposited under one film forming condition, which may be advantageous in the process. However, because the stress of the entire inorganic layer IL' is large, a film lifting phenomenon may occur.

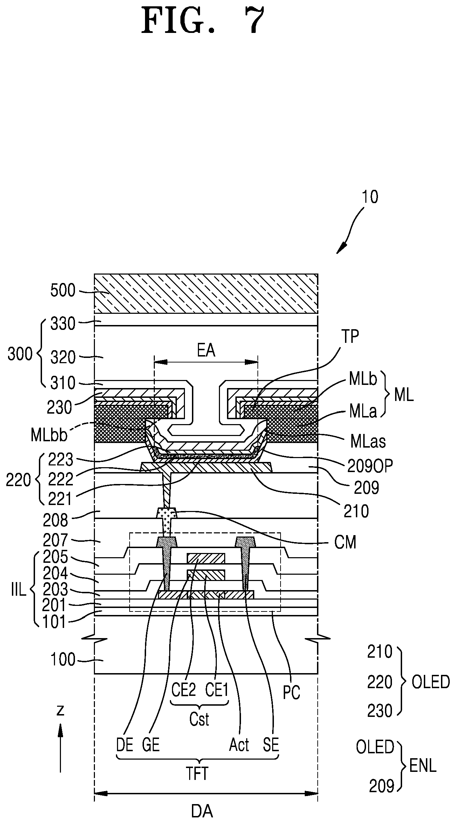

FIG. 7 is a cross-sectional view schematically illustrating a portion of a display apparatus, according to an embodiment. FIG. 7 is a modified embodiment of FIG. 4A, and a difference will be mainly described and to the extent that an element is not described in detail with respect to this figure, it may be understood that the element is at least similar to a corresponding element that has been described elsewhere within the present disclosure.

FIG. 7 illustrates an example of a lower structure in which the inorganic layer IL is arranged. However, the disclosure is not necessarily limited thereto, and may include various lower structures, in which the adhesive strength of the inorganic layer IL is increased.

Referring to FIG. 7, the organic light-emitting diode OLED as the light-emitting element and the sub-pixel circuit PC electrically connected to the organic light-emitting diode OLED may be arranged in the display area DA of the substrate 100.

The light-emitting element layer ENL may be disposed on the second organic insulating layer 208. The light-emitting element layer ENL may include the organic light-emitting diode OLED as the light-emitting element and a first bank layer 209. The organic light-emitting diode OLED may include the sub-pixel electrode 210, the intermediate layer 220, and the opposite electrode 230.

The sub-pixel electrode 210 of the organic light-emitting diode OLED may be disposed on the second organic insulating layer 208. The first bank layer 209 may cover the edge of the sub-pixel electrode 210 on the second organic insulating layer 208. The first bank layer 209 may have the opening 209OP that exposes the central portion of the sub-pixel electrode 210. The opening 209OP may define an emitting area EA of the organic light-emitting diode OLED.

A second bank layer ML may be disposed on the first bank layer 209. In an embodiment, the second bank layer ML may include a metal. However, the disclosure is not necessarily limited thereto. In an embodiment, the second bank layer ML may include an organic material. When the second bank layer ML includes an organic material, the second bank layer ML may be formed of the same material in the same process as the first bank layer 209.

The second bank layer ML may include a first sub-layer MLa and a second sub-layer MLb disposed on the first sub-layer MLa. The second sub-layer MLb may include a tip TP that protrudes in a side direction (e.g., a direction toward the opening 209OP of the first bank layer 209) from a portion where the lower surface MLbb of the second sub-layer MLb and the side surface MLas of the first sub-layer MLa meet. The tip TP may be positioned on at least one side of one opening 209OP of the first bank layer 209. FIG. 7 illustrates that tips TPs are positioned on both sides of one opening 209OP of the first bank layer 209.

The intermediate layer 220 of the organic light-emitting diode OLED may include the emission layer 222, the first functional layer 221, and the second functional layer 223. The emission layer 222 may be disposed on the sub-pixel electrode 210 within the opening 209OP of the first bank layer 209.

Some of the layers included in the organic light-emitting diode OLED, for example, the first and second functional layers 221 and 223, may be disconnected or separated by the tip TP. The opposite electrode 230 may also be disconnected or separated by the tip TP. In an embodiment, the separated portions of the opposite electrode 230, which are disposed on the emission layer 222, may contact the second bank layer ML including a metal material and be electrically connected to each other.

An encapsulation layer 300 may be disposed on the organic light-emitting diode OLED. In an embodiment, the encapsulation layer 300 may include the first inorganic encapsulation layer 310, the organic encapsulation layer 320, and the second inorganic encapsulation layer 330. The first inorganic encapsulation layer 310 may continuously cover the inner surface and tips TPs of the second bank layer ML, and the opening 209OP of the first bank layer 209.

The organic encapsulation layer 320 may be disposed on the first inorganic encapsulation layer 310 and fill the space between the opening 209OP of the first bank layer 209 and the tips TPs of the second bank layer ML. The second inorganic encapsulation layer 330 may be disposed on the organic encapsulation layer 320.

In an embodiment, the second inorganic encapsulation layer 330 of the encapsulation layer 300 may correspond to the inorganic layers IL and IL' described with reference to FIGS. 5 and 6. As described above, a compressive stress of at least a portion of the inorganic layer IL or IL' may be about 200 MPa or greater. In an embodiment, a compressive stress of at least a portion of the inorganic layer IL or IL' may be about 200 MPa to about 400 MPa. In an embodiment, a compressive stress of at least a portion of the inorganic layer IL or IL' may be about 250 MPa to about 400 MPa. In this case, compared to a case where the compressive stress of the entire inorganic layer is lower than about 200 MPa, the inorganic layer IL or IL' may have relatively high internal stress, which may increase the possibility of film lifting.

However, according to one or more embodiments, the encapsulation layer 300 including the second inorganic encapsulation layer 330 corresponding to the inorganic layer IL or IL' may be disposed on the second bank layer ML having an anchor-shaped tip TP. When the inorganic layer IL or IL' is disposed on such a lower structure, the adhesion between the lower structure and the inorganic layer IL or IL' may increase. Therefore, the film lifting phenomenon of the inorganic layer IL or IL' may be reduced or prevented.

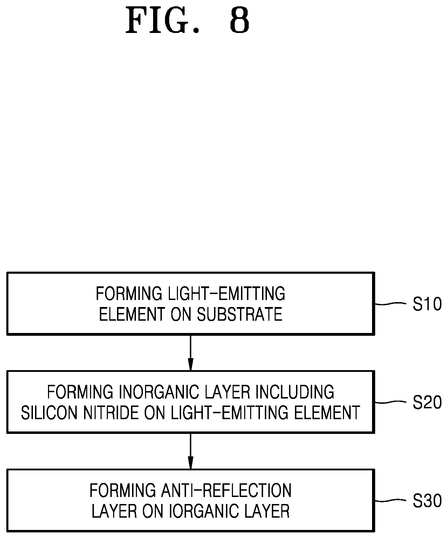

FIG. 8 is a flowchart schematically illustrating a method of manufacturing a display apparatus, according to an embodiment. For example, FIG. 8 shows a method of manufacturing a display apparatus including the inorganic layer IL or IL' and the anti-reflection layer 500 illustrated in FIGS. 5 and 6. Hereinafter, the method of manufacturing the display apparatus of FIG. 5 will be mainly described.

Referring to FIGS. 5 and 8, the method of manufacturing a display apparatus according to an embodiment may include forming a light-emitting element on a substrate (S10), forming an inorganic layer IL (see FIG. 5) including silicon nitride on the light-emitting element (S20), and forming the anti-reflection layer 500 on the inorganic layer IL (S30).

In operation S 10, after forming at least one insulating layer and at least one transistor on the substrate, a light-emitting element including a sub-pixel electrode, an intermediate layer, and an opposite electrode, such as an organic light-emitting diode, may be formed.

In operation S20, the inorganic layer IL may be formed on the light-emitting element. The inorganic layer IL may include silicon nitride. The inorganic layer IL may be formed by a chemical vapor deposition method, such as plasma chemical vapor deposition.

In an embodiment, the inorganic layer IL may be formed by a low temperature process. The forming of the inorganic layer IL may be performed at a temperature of about 100 °C or lower. Damage to the organic layer disposed under the inorganic layer IL may be prevented.

In the process of forming the inorganic layer IL, nitrogen (N₂), silane (SiH₄), and ammonia (NH₃) gas for synthesizing silicon nitride (SiNx) may be injected. Also, hydrogen (H₂) may be injected together. The properties, for example, mechanical properties, of the inorganic layer IL may vary depending on the plasma chemical vapor deposition process conditions. For example, the properties, for example, mechanical properties, of the inorganic layer IL may vary depending on the content of nitrogen (N₂), silane (SiH₄), ammonia (NH₃), and hydrogen (H₂) injected.

By varying the process conditions for each time period in the process of forming the inorganic layer IL, the inorganic layer IL may be formed to have different characteristics for each portion. In an embodiment, the inorganic layer IL may include multiple layers. In an embodiment, the forming of the inorganic layer IL may include forming a first layer ILa, and forming a second layer ILb on the first layer ILa. The second layer ILb may include an upper surface of the inorganic layer IL. A thickness t2 of the second layer ILb may be about 10% to about 15% of a total thickness t1 of the inorganic layer IL.

In an embodiment, the amount of ammonia (NH₃) injected in the forming of the second layer ILb of the inorganic layer IL may be lower than the amount of ammonia (NH₃) injected in the forming of the first layer ILa of the inorganic layer IL.

In an embodiment, the amount of ammonia (NH₃) injected in the forming of the second layer ILb of the inorganic layer IL may be about 200 sccm to about 800 sccm. In an embodiment, the amount of ammonia (NH₃) injected in the forming of the second layer ILb of the inorganic layer IL may be about 300 sccm to about 700 sccm.

In an embodiment, the amount of hydrogen (H₂) injected in the forming of the second layer ILb of the inorganic layer IL may be greater than the amount of hydrogen (H₂) injected in the forming of the first layer ILa of the inorganic layer IL.

In an embodiment, the amount of hydrogen (H₂) injected in the forming of the second layer ILb of the inorganic layer IL may be about 3000 sccm to about 25000 sccm. In an embodiment, the amount of hydrogen (H₂) injected in the forming of the second layer ILb of the inorganic layer IL may be about 4500 sccm to about 25000 sccm.

In an embodiment, the content ratio of ammonia (NH₃) to hydrogen (H₂) injected in the forming of the second layer ILb of the inorganic layer IL may be about 0.03 to about 0.1. In an embodiment, the content ratio of ammonia (NH₃) to hydrogen (H₂) injected in the forming of the second layer ILb of the inorganic layer IL may be about 0.05 to about 0.1.

A compressive stress of at least a portion of the inorganic layer IL may be about 200 MPa or greater. In an embodiment, a compressive stress of at least a portion of the inorganic layer IL may be about 200 MPa to about 400 MPa. In an embodiment, a compressive stress of at least a portion of the inorganic layer IL may be about 250 MPa to about 400 MPa. At least a portion of the inorganic layer IL may be a portion including the upper surface of the inorganic layer IL. In an embodiment, a compressive stress of the second layer ILb of the inorganic layer IL may be about 200 MPa or greater, while a compressive stress of the first layer ILa of the inorganic layer IL may be lower than about 200 MPa.

In an embodiment, as illustrated in FIG. 6, a compressive stress of the entire inorganic layer IL' may be about 200 MPa or greater. In an embodiment, a compressive stress of the entire inorganic layer IL' may be about 200 MPa to about 400 MPa. In an embodiment, a compressive stress of the entire inorganic layer IL' may be about 250 MPa to about 400 MPa. The forming of the inorganic layer IL' of FIG. 6 may be performed under process conditions equivalent to process conditions of the forming of the second layer ILb of the inorganic layer IL of FIG. 6.

In operation S30, the anti-reflection layer 500 may be formed on the inorganic layer IL. In an embodiment, the anti-reflection layer 500 may be disposed directly on the inorganic layer IL. The anti-reflection layer 500 may be a polarizing film.

The display apparatus according to the embodiment may be applied to various electronic apparatuses. An electronic apparatus according to an embodiment of the present disclosure may include the display apparatus (e.g., the display apparatus of FIG. 1) described above, and may further include modules or apparatuses having additional functions in addition to the display apparatus.

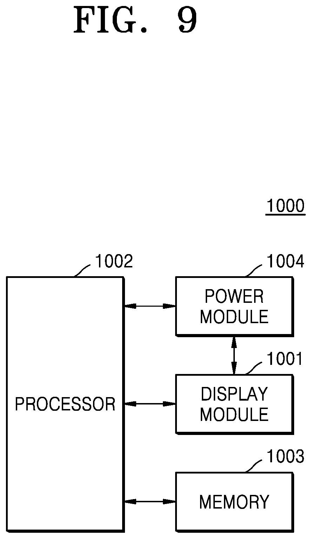

FIG. 9 is a block diagram of an electronic apparatus according to an embodiment.

Referring to FIG. 9, an electronic apparatus 1000 according to an embodiment may include a display module 1001, a processor 1002, a memory 1003, and a power module 1004.

The processor 1002 may include at least one of a central processing unit (CPU), an application processor (AP), a graphic processing unit (GPU), a communication processor (CP), an image signal processor (ISP), and a controller.

The memory 1003 may store data information necessary for the operation of the processor 1002 or the display module 1001. When the processor 1002 executes an application stored in the memory 1003, an image data signal and/or an input control signal may be transmitted to the display module 1001, and the display module 1001 may process a signal received and output image information through a display screen.

The power module 1004 may include a power supply module such as a power adapter or a battery device, and a power conversion module that converts the power supplied by the power supply module to generate power necessary for the operation of the electronic apparatus 1000.

At least one of the components of the electronic apparatus 1000 described above may be included in the display apparatus according to the embodiments described above. In addition, a part among the individual modules functionally included in one module may be included in the display apparatus, and another part may be provided separately from the display apparatus. For example, the display apparatus may include the display module 1001, and the processor 1002, the memory 1003, and the power module 1004 may be provided in the form of other apparatuses within the electronic apparatus 1000 except for the display apparatus.

In an embodiment, the display module 1001 included in the display apparatus may drive based on the image data signal and the input control signal received from the processor 1002.

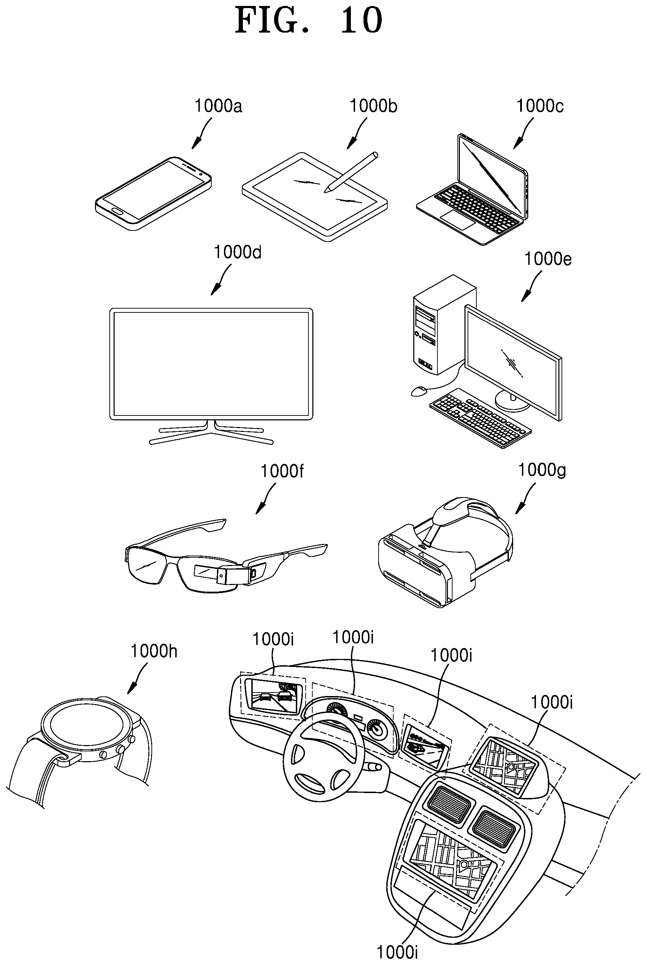

FIG. 10 depicts schematic diagrams of electronic apparatuses according to various embodiments.

Referring to FIG. 10, various electronic apparatuses to which display apparatuses according to embodiments are applied may include not only image display electronic apparatuses such as a smart phone 1000a, a tablet PC 1000b, a laptop 1000c, a TV 1000d, and a desk monitor 1000e, but also a wearable electronic apparatus including display modules such as smart glasses 1000f, a head mounted display 1000g, and a smart watch 1000h, and a vehicle electronic apparatus 1000i including a dashboard, a center fascia, and display modules such as a CID (Center Information Display) and a room mirror display disposed in the dashboard.

Table 1 below shows process conditions for forming inorganic layers, according to an embodiment and a comparative example. Specifically, process conditions for forming uppermost portions of the inorganic layers, according to an embodiment and a comparative example are shown.

**[Table 1]**

| Division | Power (W) | Pressure (mTorr) | H₂ (sccm) | N₂ (sccm) | SiH₄ (sccm) | NH₃ (sccm) | Temperature (°C) |
|---|---|---|---|---|---|---|---|
| Comparative Example | 1200 | 1500 | 1000 | 2000 | 180 | 800 | 100 |
| Embodiment | 600 | 1500 | 4500 | 1500 | 150 | 390 | 65 |

After forming the inorganic layers of the embodiment and the comparative example, compressive stresses of uppermost portions of the inorganic layers were measured. **In** addition, wet high temperature storage (WHTS) reliability evaluation was performed on the inorganic layers of the embodiment and the comparative example. Specifically, the inorganic layers of the embodiment and the comparative example were placed at a temperature of 85 °C and a humidity of 85% for 500 hours, and then oxidation was evaluated. Oxidation of the inorganic layer was confirmed by analyzing XPS (X-ray photoelectron spectroscopy). **In** addition, discoloration of the anti-reflection layers on the inorganic layers of the embodiment and the comparative example was observed.

Table 2 below shows the compressive stresses at the uppermost portions of the inorganic layers of the embodiment and the comparative example, and whether or not the anti-reflection layers were discolored.

**[Table 2]**

| Division | Compressive Stress ((-)MPa) | Whether Anti-reflection Layer is discolored |
|---|---|---|
| Comparative Example | 69 | O |
| Embodiment | 380 | X |

In the comparative example, the SiO₂ peak increased after the high temperature and high humidity reliability evaluation in the XPS results. It may be predicted that the composition of oxygen (O) in the silicon nitride constituting the inorganic layer has increased and oxidation has occurred according to a following reaction formula.

### Reaction Formula: Si₃N₄ + H₂O → 3 SiO₂ + 4NH₃

The XPS results of the embodiment did not show significant changes in the composition of Si, O, and N even after the high temperature and high humidity reliability evaluation. The embodiment shows that oxidation did not progress significantly.

Referring to Table 1 and Table 2, it is seen that the uppermost portion of the inorganic layer of the comparative example exhibits a compressive stress of lower than 200 MPa, and discoloration of the anti-reflection layer has occurred. It is seen that the uppermost portion of the inorganic layer of the embodiment exhibits a compressive stress of 200 MPa or greater, and no discoloration of the anti-reflection layer has occurred.

When forming an inorganic layer including silicon nitride at low temperature and/or low power, the inorganic layer may have more internal defects and more dangling bonds compared to when forming an inorganic layer including silicon nitride at a relatively high temperature. Therefore, the inorganic layer which is formed at low temperature and/or low power may be easily oxidized in a high temperature and high humidity environment, and components or gases within the inorganic layer may react with the anti-reflection layer and discolor the anti-reflection layer.

However, according to one or more embodiments, by optimizing the composition of the gas injected in the plasma chemical vapor deposition process, the properties, for example, mechanical properties, of the uppermost portion of the inorganic layer may be improved. For example, by controlling the contents of hydrogen (H₂) and ammonia (NH₃) in a gas, a compressive stress of the portion including the uppermost portion of the inorganic layer may be about 200 MPa or greater. By increasing the hydrogen (H₂) content in the gas, hydrogen may be bonded to internal defects. Also, by reducing the content of ammonia (NH₃) in the gas, the amount of unreacted ammonia (NH₃) present near the internal defect may be reduced. When the internal defects of the inorganic layer are reduced, the compressive stress may increase. As the internal defects and the amount of unreacted ammonia (NH₃) in the inorganic layer decrease, the discoloration phenomenon of the anti-reflection layer disposed on the inorganic layer may be reduced.

According to one or more embodiments, a display apparatus with increased reliability, a method of manufacturing the display apparatus, and an electronic apparatus including the display apparatus may be provided. However, the scope of the disclosure is not limited thereto.

As described above, the one or more embodiments have been described with reference to the accompanying drawings, but the embodiments should be considered in a descriptive sense only. Those of ordinary skill in the art will understand that various modifications and changes to the embodiments may be made therefrom. Therefore, the true technical scope of protection of the disclosure should be defined by the technical idea of the present disclosure.

## Claims

1. A display apparatus, comprising:
a light-emitting element (LED) disposed on a substrate;
an inorganic layer (IL, IL') disposed on the light-emitting element (LED); and
an anti-reflection layer (500) disposed on the inorganic layer (IL, IL'),
wherein a compressive stress of at least a portion of the inorganic layer (IL, IL') is 200 MPa or greater.

2. The display apparatus of claim 1,
wherein the inorganic layer (IL, IL') includes silicon nitride.

3. The display apparatus of claim 1 or claim 2, wherein:
(i) the anti-reflection layer (500) includes a polarizing film; and/or
(ii) the anti-reflection layer (500) is in direct contact with the inorganic layer (IL, IL').

4. The display apparatus of any one of claims 1 to 3, wherein
the inorganic layer (IL) includes a first layer (Ila), and a second layer (ILb) disposed on the first layer (ILa), the second layer (ILb) being an upper surface of the inorganic layer (IL), and
wherein a compressive stress of the second layer (ILb) is different from a compressive stress of the first layer (ILa).

5. The display apparatus of claim 4,
wherein the compressive stress of the second layer (ILb) is greater than the compressive stress of the first layer (ILa), optionally wherein the compressive stress of the second layer (ILb) is 200 MPa or greater.

6. The display apparatus of claim 4 or claim 5, wherein:
(i) the density of the second layer (ILb) is 2.0 g/cm³ or greater; and/or
(ii) a thickness of the second layer (ILb) is within a range of from 10% to 15% of a total thickness of the inorganic layer (IL).

7. The display apparatus of any one of claims 1 to 3,
wherein a compressive stress of an entirety of the inorganic layer (IL)' is 200 MPa or greater.

8. The display apparatus of any one of claims 1 to 7,
further comprising an encapsulation layer (300) covering the light-emitting element (LED),
wherein the encapsulation layer (300) includes a first inorganic encapsulation layer (310), a second inorganic encapsulation layer (330) disposed on the first inorganic encapsulation layer (310), and an organic encapsulation layer (320) disposed between the first inorganic encapsulation layer (310) and the second inorganic encapsulation layer (330).

9. The display apparatus of claim 8, wherein:
(i) the inorganic layer (IL, IL') includes the second inorganic encapsulation layer (330); or
(ii) the display apparatus further comprises:
a touch sensor layer (400) disposed on the encapsulation layer (300),
wherein the touch sensor layer (400) includes:
a first insulating layer (410);
a first conductive layer (MTL1) disposed on the first insulating layer (410);
a second insulating layer (420) disposed on the first conductive layer (MTL1);
a second conductive layer (MTL2) disposed on the second insulating layer (420); and
a third insulating layer (430) disposed on the second conductive layer (MTL2), wherein the inorganic layer (IL, IL') includes the third insulating layer (430).

10. A method of manufacturing a display apparatus, the method comprising:
forming a light-emitting element (LED) on a substrate (S10);
forming an inorganic layer (IL, IL') including silicon nitride on the light-emitting element (LED) (S20); and
forming an anti-reflection layer (500) on the inorganic layer (IL, IL') (S30),
wherein a compressive stress of at least a portion of the inorganic layer (IL, IL') is 200 MPa or greater.

11. The method of claim 10,
wherein the forming the inorganic layer (IL, IL') is
performed at a temperature of 100 °C or lower.

12. The method of claim 10 or claim 11, wherein
the forming the inorganic layer (IL) includes:
forming a first layer (ILa); and
forming a second layer (ILb) on the first layer (ILa),
wherein a compressive stress of the second layer (ILb) is 200 MPa or greater.

13. The method of claim 12, wherein:
(i) in the forming of the inorganic layer (IL),
an amount of ammonia injected in the forming of the second layer (ILb) is less than an amount of ammonia injected in the forming of the first layer (ILa); and/or
(ii) in the forming of the inorganic layer (IL),
an amount of hydrogen injected in the forming of the second layer (ILb) is greater than an amount of hydrogen injected in the forming of the first layer (ILa).

14. An electronic apparatus (1000) comprising a display apparatus,
wherein the display apparatus includes:
a light-emitting element (LED) disposed on a substrate;
an inorganic layer (IL, IL') disposed on the light-emitting element (LED); and
an anti-reflection layer (500) disposed on the inorganic layer (LED),
wherein a compressive stress of at least a portion of the inorganic layer (IL, IL') is 200 MPa or greater.

15. The electronic apparatus (1000) of claim 14, further comprising:
a display module (1001);
a processor (1002);
a power module (1004); and
a memory (1003),
wherein the display apparatus includes one of the display module (1001), the processor (1002), the power module (1004), or the memory (1003).
